# EUROPÄISCHE PATENTANMELDUNG

(11) **EP 2 477 212 A1**
(43) Veröffentlichungstag der Anmeldung: **18.07.2012**
(21) Anmeldenummer: 12152997.8
(22) Anmeldetag: 09.06.2008
(51) Int. Cl.: H01L 21/20, H01L 21/02

(54) **Polykristalline Silizium-Dünnschichten hergestellt durch Titan-unterstützten Metall-induzierten Schichtaustausch**

(62) Teilanmeldung aus: 08157885.8
(71) Anmelder: Dritte Patentportfolio Beteiligungsgesellschaft mbH & Co. KG, 12529 Schönefeld (DE)
(72) Erfinder: Stutzmann, Martin, 85435 Erding (DE); Lechner, Robert, 81373 München (DE); Scholz, Michael, 82288 Kottgeisering (DE)
(74) Vertreter: Zech, Stefan Markus

(57) **Zusammenfassung**

Verfahren zur Herstellung polykristalliner Schichten mit den Verfahrensschritten:
- Aufbringen einer Schichtfolge, die wenigstens ein amorphe Ausgangsschicht, eine metallische Aktivatorschicht und eine zwischen Ausgangsschicht und Aktivatorschicht angeordnete Oxidschicht umfasst, auf ein Substrat; und
- Durchführen einer Wärmebehandlung zur Ausbildung einer polykristallinen Endschicht, wobei die Oxidschicht auf der Basis eines Oxids eines Übergangsmetalls hergestellt wird, mit dem eine während der Wärmebehandlung stabile Oxidschicht erzeugbar ist.

## Beschreibung

### Technisches Gebiet

Die Herstellung von kristallinen Silizium-Germanium (SiGe) Dünnschichten auf kostengünstigen Substraten wie z.B. Glas ist von fundamentaler Bedeutung für großflächige elektronische Bauelemente. Hierzu zählen beispielsweise Dünnschicht-Solarzellen und Bildschirme, die auf Basis der Dünnschicht-Transistor-Technologie (TFT-Technologie) beruhen.

Die Funktionsfähigkeit dieser Bauelemente wird in erster Linie durch die elektrischen Eigenschaften des halbleitenden Materials bestimmt. Diese Eigenschaften sind stark mit der mikroskopischen Struktur korreliert, wobei man zwischen amorphen, nanokristallinen, mikrokristallinen, polykristallinen und einkristallinen Materialien unterscheidet. Im Allgemeinen wird die Qualität der Bauelemente mit zunehmender Kristallinität (amorph -> kristallin) verbessert. Die Schaltzeiten von amorphen TFT-Bildschirmen sind beispielsweise länger als die von mikrokristallinen, die Wirkungsgrade von amorphen Solarzellen geringer als die von polykristallinen.

### Stand der Technik

Zur Glas-kompatiblen Niedertemperatur-Kristallisation (T < 600 °C) von amorphen Silizium-Germanium werden vor allem die Laser-induzierte Kristallisierung (Laser-induced Crystallization), LIC) und die Metall-induzierte Kristallisierung (Metal-induced Crystallization, MIC) wissenschaftlich untersucht bzw. industriell eingesetzt. Die Festphasen-Kristallisierung (Solid Phase Crystallization, SPC) erfordert Temperaturen größer als 600 °C und ist nicht kompatibel mit der Verwendung von konventionellen Glas-Substraten.

Bei der LIC werden amorphe Halbleiterschichten durch intensives Laser-Licht kurzzeitig aufgeschmolzen (T = 1500 °C), so dass sich mikrokristallines Material mit Korngrößen von bis zu 5 µm bildete [Eis03]. Im Gegensatz dazu stellt die MIC ein echtes Niedertemperatur-Verfahren (T < 600 °C) dar [Her72]. Die Kristallisation von amorphen Halbleitern wurde sowohl in Metall/Halbleiter Schichtsystemen als auch in Metall-dotierten amorphen Schichten beobachtet [Rad91], [Cha01].

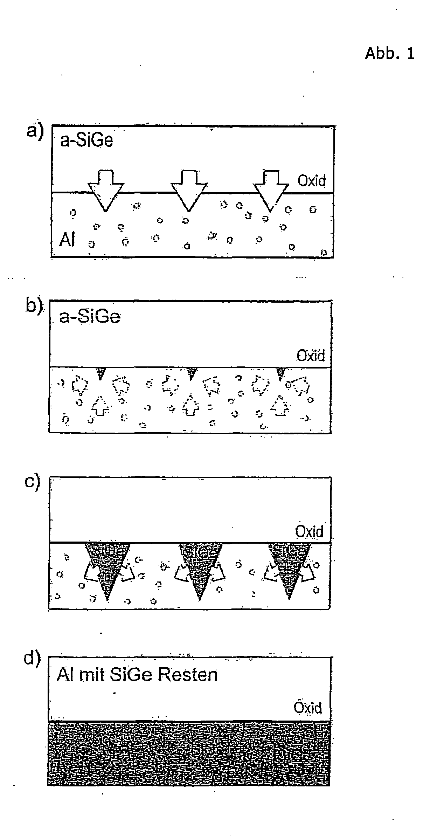

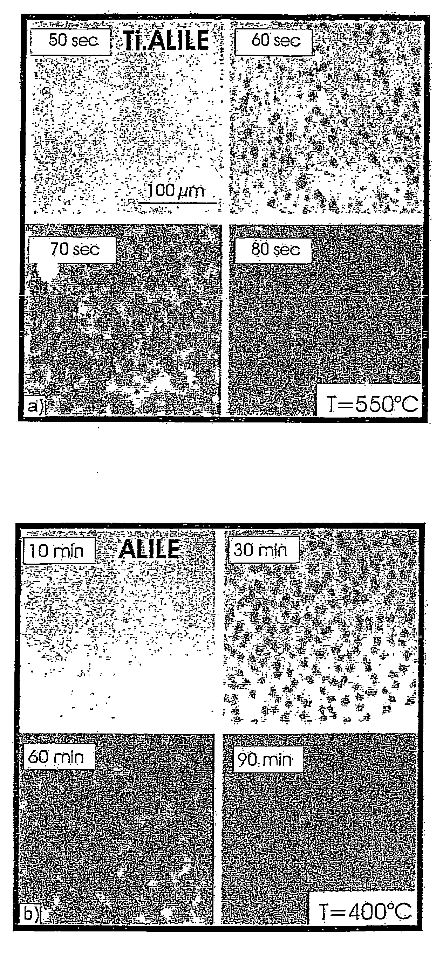

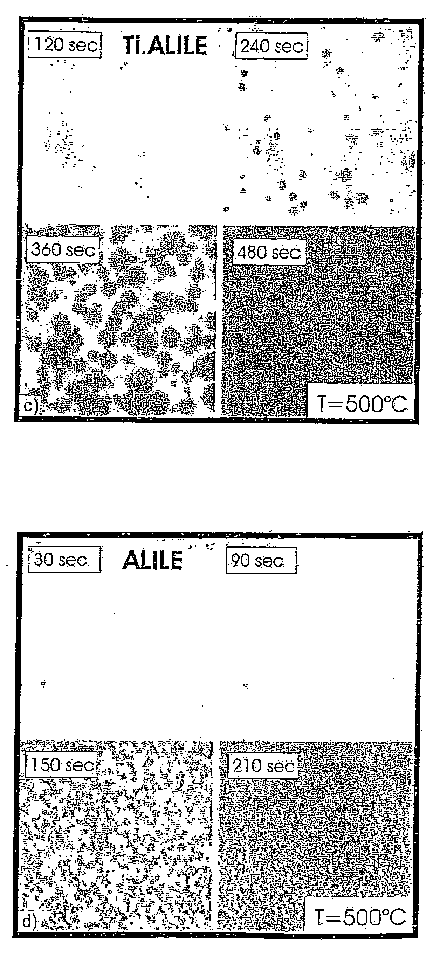

Ein viel versprechendes, großflächig anwendbares und zur Zeit intensiv erforschtes Verfahren stellt der Aluminium-induzierte Schichtaustausch (Aluminum-induced Layer Exchange, ALILE) von Silizium, Germanium bzw. Silizium-Germanium-Legierungen dar [Maj77], [Nas98], [Gju04]. Amorphes Silizium-Germanium wird dabei auf Aluminium-beschichtete Glassubstrate aufgebracht und unterhalb der eutektischen Temperatur des Aluminium-Silizium-Germanium-Systems (Te = 420 °C) getempert. Während des Temperns lösen sich Silizium- und Germanium-Atome aus der amorphen Schicht in der Aluminium-Schicht. Wenn die Sättigungsgrenze erreicht ist, fällen kristalline Si-Ge-Keime aus. Diese wachsen lateral und bilden am Ende eine geschlossene polykristalline Schicht, welche die gleiche Schichtdicke aufweist, wie die ursprüngliche Aluminium-Schicht. In Abb. 1 ist das Verfahren schematisch dargestellt.

### Abb. 1;

a) Typisches Schichtsystem für den Aluminium-induzierten Schichtaustausch von Silizium-Germanium. Zwischen dem Aluminium (ca. 200 nm) und dem amorphen Silizium-Germanium (ca. 200 nm) befindet sich eine in der Skizze angedeutete dünne Aluminium-Oxid-Schicht. Wird diese Schichtstruktur bei Temperaturen unterhalb der eutektischen Temperatur des Aluminium-Silizium-Germanium-Systems (420 °C) getempert.
b) Es bilden sich an der Grenzfläche zwischen dem Aluminium und der amorphen SiGe-Schicht kristalline Silizium-Germanium-Keime aus, die in die Aluminium-Schicht hineinwachsen.
c) Das vertikale Wachstum wird durch die Substratoberfläche begrenzt. Anschließend findet laterales Wachstum der Kristallite bis zur Bildung einer geschlossenen polykristallinen Silizium-Germanium-Schicht statt.
d) Das sich nach dem Prozess an der Oberfläche befindende Aluminium kann durch nasschemische Verfahren entfernt werden (z.B. Ätzen in Salzsäure). Zurück bleibt eine polykristalline Silizium-Germanium-Schicht auf Glas mit lateralen Kristallitgrößen bis zu 50 µm.

Dieser Prozess konnte in unserer Gruppe auf das Materialsystem: Silber Silizium-Germanium erweitert werden. Der Prozess verläuft makroskopisch analog zum ALILE-Prozess [Gju05].

### Nachteile bzw. Probleme der bekannten Technik

Beim ALILE-Prozess mit Aluminiumoxid an der Grenzfläche ist für das Erlangen einer großkörnigen polykristallinen Schicht (Korngrößen > 20 µm) eine niedrige Prozesstemperatur (typischerweise unter 500 °C) nötig. Dies führt aber zu sehr langsamen Prozessen, die mehrere Stunden dauern können.

Beim Silber-induzierten Schichtaustausch (AgILE) Prozess zeigte sich, dass die Reproduzierbarkeit ein großes Problem darstellt. Dies liegt wahrscheinlich an der sehr instabilen Silberoxidschicht, die bei dem Prozess eine Diffusionsbarriere darstellt und für den Schichtaustausch essentiell ist.

Beim AgILE Prozess ist im Gegensatz zum ALILE Prozess ein Schichtaustausch in umgekehrter Schichtfolge (Si/SiO₂/Silber) nicht möglich. Diese Schichtfolge würde sich aber für die Solarzellenproduktion anbieten, da man bei diesem Prozess einen sehr gut reflektierenden Silberrückkontakt unterhalb der polykristallinen Halbleiterschicht erhalten würde.

### Lösung durch Titan-unterstützten Metall-induzierten Schichtaustausch

Der von uns entwickelte und bisher in der Literatur noch nicht beschriebene Titan-unterstützte Metall induzierte Schichtaustausch (Titan-assisted metal-induced layer exchange, Ti.MILE) löst die oben genannten Probleme wie folgt:
a) durch das Aufbringen einer Titan-Zwischenschicht und das dadurch erfolgte Ersetzen der Aluminiumoxid- bzw. Silberoxidschicht durch eine Titanoxidschicht lässt sich beim ALILE-Prozess die Keimbildungsenergie gegenüber dem konventionellen Prozess deutlich erhöhen. Dies führt sowohl beim ALILE- als auch beim AgILE-Prozess zu deutlich größeren Kristalliten, wobei die Prozessdauer in der gleichen Größenordnung verbleibt.
b) durch das Einfügen einer Titan-Zwischenschicht wird der umgekehrte Silberinduzierte Schichtaustausch ermöglicht.

### Beschreibung des Verfahrens "Titan-unterstützter Metall-induzierter Schichtaustausch"

### Zu a)

- Auf ein amorphes oder kristallines Substrat (z.B. Glas, Quarz, Silizium-Wafer) wird eine 20-600 nm (typischerweise 200 nm) dicke Aluminium bzw. SilberSchicht mit einem geeigneten Verfahren aufgebracht (z.B. thermisches Verdampfen, Elektronenstrahl-Verdampfen, Sputtern, elektrochemisches Aufbringen des Metalls, etc.). Auf diese wird eine dünne Titanschicht (typischerweise 2-10 nm) aufgebracht.
- Nach diesem Depositions-Prozess wird das Titan für kurze Zeit (einige Minuten) der Umgebungsluft ausgesetzt. Dieser Schritt ist nicht zwingend notwendig, verbessert aber die Oberflächenstruktur der resultierenden polykristallinen Halbleiter-Schicht.
- Auf das Metall-Titan Schichtsystem wird nun eine Silizium-Germanium-Schicht mit einem geeigneten Verfahren aufgebracht (z.B. thermisches Verdampfen, Elektronenstrahl-Verdampfen, Sputtern, Gasphasenabscheidung, etc.). Die Dicke dieser Schicht sollte vergleichbar mit der Dicke der Metall-Schicht sein.
- Die so gewonnene Probenstruktur wird unterhalb der eutektischen Temperaturen des jeweiligen Materialsystems getempert (z.B. Si-Al 570 °C; Si-Ag 830 °C, ...), bis sich die Schichtfolge spontan austauscht. Abhängig von der verwendeten Temperatur dauert dieser Prozess zwischen einigen Sekunden bis hin zu einigen zehn Stunden. Die ursprüngliche Schichtstruktur Glas/Metall/ Titan/amorphes Silizium-Germanium wird dabei in eine Glas/polykristallines Silizium-Germanium/Titan/Metall Struktur umgewandelt.
- Das Aluminium kann nasschemisch, z.B. mit Salzsäure, von der getemperten Probe entfernt werden. Titan bzw. Titanoxid lässt sich z.B. nasschemisch mit Flußsäure entfernen. Als Ergebnis erhält man eine polykristalline Silizium-Germanium-Schicht auf Glas.

### Zu b)

- Beim umgekehrten Silber-induzierten Schichtaustausch wird zuerst die Silizium-Germanium-Schicht mit einer der oben genannten Methoden deponiert.
- Diese kann einige Zeit an Luft gelagert werden oder es kann direkt eine dünne (2-10 nm) dicke Titanschicht mit einer geeigneten Depositionsmethode aufgebracht werden (siehe a).
- Diese Schichtfolge sollte für einige Minuten einer sauerstoffhaltigen Atmosphäre ausgesetzt werden, um die Bildung einer Titanoxidschicht zu ermöglichen. Dies ist nicht zwingend notwendig, verbessert aber die Qualität der Schichten.
- Auf dieses Schichtsystem wird nun eine Silberschicht abgeschieden. Die Schichtdicke ist hierbei ähnlich der amorphen Silizium-Germanium-Schicht.
- Die so gewonnene Probenstruktur wird unterhalb der eutektischen Temperaturen des jeweiligen Materialsystems getempert (Si-Ag 830 °C; Ge-Ag 650 °C), bis sich die Schichtfolge spontan austauscht. Abhängig von der verwendeten Temperatur dauert dieser Prozess zwischen einigen Minuten bis hin zu einigen zehn Stunden. Die ursprüngliche Schichtstruktur Glas/amorphes Silizium-Germanium/Titan/Metall wird dabei in eine Glas/Metall/Titan/polykristallines Silizium-Germanium Struktur umgewandelt.

### Wesentliche Vorteile gegenüber bereits bekannten Verfahren

Der Vorteil des hier beschriebenen Verfahrens lässt sich wie folgt zusammenfassen:
- *Die dünne Zwischenschicht aus Titan erhöht die Aktivierungsenergie für die Bildung neuer Kristallite und führt so bei vergleichbaren Temperaturen zu deutlich größeren Kristalliten, ohne dabei aber den Gesamt-Prozess zu verlangsamen.*

Die Modifikation des bereits bekannten "Aluminium-induzierten Schichtaustauschs" durch das Einbringen einer zusätzlichen funktionalen Dünnschicht aus Titan, ist als das wesentlich Neue der Erfindung anzusehen.

### Literaturverzeichnis

- [ChaO1I]: I. Chambouleyron, F. Fajardo, A.R. Zanatta, Appl. Phys. Lett. 79, 3233 (2001)
- [Eis03]: C. Eisele, M. Berger, M. Nerding, H.P. Strunk, C.E. Nebel, M. Stutzmann, Thin Solid Films 427, 176 (2003)
- [Gju04]: M. Gjukic, M. Buschbeck, R. Lechner, M. Stutzmann, Appl. Phys. Lett. 85, 2134 (2004)
- [Gju05]: M. Gjukic, M. Scholz, and M. Stutzmann, Erfindungsmeldung: Silber-induzierter Schichtaustausch (AgILE)
- [Her72]: S.R. Herd, P. Chaudhari, H.M. Brodsky, J. Cryst-Non Solids 7, 309 (1972)
- [Maj77]: G. Majni, G. Ottaviani, Appl. Phys. Lett. 31, 125 (1977)
- [Nas98]: O. Nast, T. Puzzer, L.M. Koschier, A.B. Sproul, R.S. Wenham, Appl. Phys. Lett. 73, 3214 (1998)
- [Rad91]: G. Radnoczi, A. Robertsson, H.T.G. Hentzell, S.F. Gong, M.-A. Hasan, J. Appl. Phys. 69 (1991) 6394

Weitere Anlagen: Forschungsantrag zum Förderkennzeichen 0329986

## Patentansprüche

1. Verfahren zur Herstellung polykristalliner Schichten mit den Verfahrensschritten:
- Aufbringen einer Schichtfolge, die wenigstens eine amorphe Ausgangsschicht, eine metallische Aktivatorschicht und eine zwischen Ausgangsschicht und Aktivatorschicht angeordnete Oxidschicht umfasst, auf ein Substrat; und - Durchführen einer Wärmebehandlung zur Ausbildung einer polykristallinen Endschicht;
**dadurch gekennzeichnet, dass** die Oxidschicht auf der Basis eines Oxids eines Übergangsmetalls hergestellt wird, mit dem eine während der Wärmebehandlung stabile Oxidschicht erzeugbar ist.

2. Verfahren nach Anspruch 2,
**dadurch gekennzeichnet, dass** die Oxidschicht auf einer zwischen Ausgangsschicht und Aktivatorschicht angeordneten metallischen Zwischenschicht ausgebildet wird.

3. Verfahren nach Anspruch 1 oder 2,
**dadurch gekennzeichnet, dass** die Oxidschicht auf der Basis von Titanoxid ausgebildet wird.

4. Verfahren nach einem der Ansprüche 1 bis 3,
**dadurch gekennzeichnet, dass** die Aktivatorschicht auf der Basis eines Metalls oder eines Übergangsmetalls hergestellt wird.

5. Verfahren nach Anspruch 4,
**dadurch gekennzeichnet, dass** die Aktivatorschicht aus Al oder Ag hergestellt wird.

6. Verfahren nach einem der Ansprüche 1 bis 5,
**dadurch gekennzeichnet, dass** die Ausgangsschicht aus wenigstens einem halbleitenden Material hergestellt wird.

7. Verfahren nach Anspruch 6,
**dadurch gekennzeichnet, dass** die Ausgangsschicht wenigstens ein Element aus der Gruppe Si, Ge enthält.

8. Vorrichtung zur Umwandlung von Strahlung in elektrische Energie,
**dadurch gekennzeichnet, dass** die Vorrichtung mithilfe eines Verfahrens nach einem der Ansprüche 1 bis 7 hergestellt ist.
